**Europäisches Patentamt**

**European Patent Office**

**Office européen des brevets**

(19)

(11) Veröffentlichungsnummer : **0 441 743 A1**

(12) # EUROPÄISCHE PATENTANMELDUNG

(21) Anmeldenummer : **91810061.1**

(22) Anmeldetag : **28.01.91**

(51) Int. Cl.⁵ : **H05K 13/00**

(30) Priorität : **05.02.90 CH 362/90**

(43) Veröffentlichungstag der Anmeldung :
**14.08.91 Patentblatt 91/33**

(84) Benannte Vertragsstaaten :
**AT BE CH DE FR GB IT LI NL SE**

(71) Anmelder : **CIBA-GEIGY AG**
**Klybeckstrasse 141**
**CH-4002 Basel (CH)**

(72) Erfinder : **Martin, Peter**
**Gerbergässlein 18**
**CH-4051 Basel (CH)**

(54) Transportvorrichtung für Platten mit empfindlicher Oberfläche, insbesondere für nassbeschichtete Leiterplatten.

(57) Eine Transportvorrichtung für Platten mit empfindlicher Oberfläche, insbesondere für nassbeschichtete Leiterplatten weist innerhalb eines gemeinsamen Gehäuses eine Belackungsstation und einen darüber angeordneten Trocknungsbereich auf. Für den Transport der Platten (2) durch den Trocknungsbereich sind Halter (3) vorgesehen, welche mindestens zwei Holme (30) mit jeweils von einem Holm (30) V-förmig ausgehenden rechförmig angeordneten Zinkreihen (31, 32) umfassen. Die freien Enden der Zinken des einen Holmes sind gegen die freien Enden der Zinken des anderen Holmes gerichtet. Die Fussenden der Halter (3) sind offen ausgebildet. Zur Abstützung der Fussenden (2b) einer innerhalb eines Halters (3) aansportierten Platte (2) ist die Transportvorrichtung mit einer synchron zu den Haltern (3) bewegbaren Stützeinrichtung (12) ausgestattet.

EP 0 441 743 A1

Fig. 1

# TRANSPORTVORRICHTUNG FÜR PLATTEN MIT EMPFINDLICHER OBERFLÄCHE, INSBESONDERE FÜR NASS-BESCHICHTETE LEITERPLATTEN

Die Erfindung betrifft eine Transportvorrichtung für Platten oder plattenförmige Werkstücke mit empfindlicher Oberfläche, insbesondere für Leiterplatten, die mit Kunststoff, z.B. UV-härtbarem Kunststoff, mit Lack oder dergleichen nass beschichtet sind, gemäss Oberbegriff des Patentanspruchs 1.

Es sind unterschiedliche Vorrichtungen zum Halten und für den Transport von Platten oder plattenförmigen Werkstücken bekannt, die berücksichtigen sollen, dass die Oberflächen der Platten geschont werden. Dies ist vor allem dann notwendig, wenn nassbeschichtete Leiterplatten von der Beschichtungs- in die Trockenstationen befördert werden sollen. Solche Leiterplatten werden nämlich mit einem Schutzlack beschichtet, der zunächst getrocknet, dann belichtet und an den unbelichteten Stellen heraus entwickelt wird.

Nach dem Beschichten müssen solche Platten gelüftet und getrocknet werden. Insbesondere bei Leiterplatten, deren beide Oberflächen beschichtet und entsprechend behandelt werden müssen, besteht das Problem, dass während der Beschichtung der zweiten Oberfläche die auf der ersten Oberfläche befindliche Schicht noch nicht ausgehärtet, also verletzungsempfindlich ist.

Aus der FR-A-2 439 734 ist eine Transportvorrichtung für Leiterplatten mit gedruckten Schaltungen bekannt, die einen Endlosförderer mit Kettenantrieb hat, wobei die Platten im Bereich des Obertrums dieses Förderelementes in nach oben offenen Schlitzen stecken, so dass ihre Oberflächen etwa vertikal orientiert sind. Dabei wird jeweils nur ein Plattenlängsrand umfasst. Eine solche Fördervorrichtung wäre für frisch beschichtete Platten ungeeignet, weil dann die Beschichtungsflüssigkeit mindestens teilweise an der Oberfläche ablaufen würde und Spuren und Tränen bilden könnte.

In der US-A-4,757,892 ist eine Leiterplattenbeschichtungsanlage beschrieben, bei der die einzelnen Behandlungsstationen hintereinander angeordnet sind. Der Transport der Leiterplatten erfolgt über Förderbänder oder -rollen und in der Trocknungsstation mit Hilfe von umlaufenden Plattenträgern. Die Plattenträger sind gabelartig zur Aufnahme der Leiterplatten ausgebildet. Die Leiterplatten werden dabei mit ihren Längsrändern in Längsnuten in den Gabelarmen der Plattenträger eingeschoben. Während auf diese Weise die Beschichtung der Leiterplatten weitgehend geschont wird, erfordert das Einschieben der Leiterplatten in die Längsnuten der Plattenträger doch eine verhältnismässig grosse Präzision. Auch ist die Anpassung der Plattenträger an unterschiedliche Plattengrössen (breiten) mit einigem zusätzlichen Aufwand verbunden. Für das beidseitige Beschichten einer Leiterplatte sind zwei Belackungsstationen und entsprechend auch zumindest zwei Tocknungsstationen erforderlich. Die Anlage ist relativ komplex und erfordert vor allem viel Platz.

Aus der US-A-4,926,789 ist eine Transportvorrichtung der eingangs genannten Art bekannt, bei welcher als Halter Greifer oder Klammern vorgesehen sind, die ein lösbar kuppelbares Halteelement haben, das jeweils an den Uebergängen von einem Vorschubmittel zu einem anderen oder von einer Bearbeitungsstation zur anderen zusammen mit der gehaltenen Platte umsetzbar oder umladbar ist. Dadurch lassen sich zwar die Platten schonend in einem beschichtungsfreien Randbereich erfassen und können während der gesamten Bearbeitung mit ihren Haltern verbunden bleiben, jedoch ist ein hoher maschineller und steuerungstechnischer Aufwand erforderlich, um einen kontinuierlichen Betrieb einer entsprechenden Transportvorrichtung zu gewährleisten. Für das beidseitige Beschichten solcher Platten müssen zwei Belackungsstationen hintereinander angeordnet werden, zwischen denen eine gesonderte Trocknungsstation eingeschaltet sein muss, damit zunächst die erste Beschichtung eine genügende Festigkeit erhält, um das Weiterbefördern der Platte zu der zweiten Belackungsstaion zu erlauben. Darüber hinaus muss Vorsorge dafür getroffen werden, dass die Halter für die Platten immer rechtzeitig ein- und ausgekuppelt und nach Durchlaufen der gesamten Transportvorrichtung wieder an den Ausgangspunkt zurücktransportiert werden können, um dort weitere Platten aufnehem zu können. Diese bekannte Anlage ist hinsichtlich ihres Aufbaues relativ komplex und nimmt auch relativ viel Platz ein.

Es besteht deshalb die Aufgabe, eine Transportvorrichtung der eingangs erwähnten Art zu schaffen, bei welcher der Vorteil erhalten bleibt, dass die Halter lediglich an unbeschichteten Stellen der Platten angreifen, aber der konstruktive und herstellungstechnische Aufwand sowie die Handhabung dieser Halter vereinfacht ist und die Halter die Möglichkeit eröffnen, die gesamte Transportvorrichtung zu vereinfachen und in ihrem Platzbedarf zu vermindern.

Die Lösung dieser Aufgabe besteht in der Ausbildung der Transportvorrichtung gemäss Kennzeichen des Patentanspruchs 1. Insbesondere wird die Transportvorrichtung mit Haltern ausgestattet, welche wenigstens zwei parallele Holme haben, an denen jeweils zwei Reihen von rechenförmig angeordneten Zinken vorgesehen sind. Die Zinken der einen Reihe des einen Holmes schliessen mit denen der zweiten Reihe dieses Holmes einen spitzen Winkel ein. Im Querschnitt gesehen sind die beiden Zinkenreihen eines Holmes V-förmig zueinander angeordnet. Die freien Enden der Zinken des einen Holmes sind etwa gegen die freien Enden der Zinken des anderen Holmes gerichtet derart, dass der zu der Längsmittelebene zwischen den beiden parallelen Holmen zunehmende lichte Abstand zwischen den Zinkenreihen wenigstens über einen Teil des zwischen den Holmen befindlichen Bereiches grösser als die Dicke einer zu haltenden Platte ist. Die Fussenden der Halter sind offen ausgebildet, um ein einfaches Be- und Entladen der Halter zu ermöglichen. Zur Abstützung der Fussenden der innerhalb der Halter transportierten Platten ist die Transportvorrichtung mit einer synchron zu den Haltern bewegbaren Stützeinrichtung ausgestattet. Vorzugsweise ist diese Stützeinrichtung als Seile, Gliederketten oder umlaufende Bänder ausgebildet, welche jeweils im Bereich des offenen Fussendes der Halter angeordnet sind.

Die gesamte erfindungsgemässe Transportvorrichtung ist einzeilig ausgeführt, mit einem integrierten Giesstisch und einer im wesentlichen oberhalb des Giesstisches angeordneten Abluft-, Trocknungs- und Kühlstrecke.

Bevorzugte Ausführungsvarianten der Transportvorrichtung sind Gegenstand der weiteren Patentansprüche.

Nachstehend wird die Erfindung mit ihren erfindungswesentlichen Einzelheiten anhand eines Ausführungsbeispiels näher erläutert. Es zeigen in teilweise schematischer Darstellung :

Fig. 1 einen Halter mit im Querschnitt dargestellter Stützeinrichtung,

Fig. 2 eine Aufsicht auf den Halter aus Fig. 1 mit angedeuteter Stützeinrichtung,

Fig. 3 eine Seitenansicht des Halters gemäss Pfeil III in Fig. 1,

Fig. 4 einen Schnitt durch die Längsmittelebene des Halters gemäss der Linie IV-IV in Fig. 1,

Fig. 5 ein weiteres Ausführungsbeipiel eines Halters mit einseitig verbundenen Holmen und angedeuteter Stützeinrichtung,

Fig. 6 eine Transportvorrichtung für Platten im Längsschnitt mit Haltern gemäss Fig. 1,

Fig. 7 eine Aufsicht der Transportvorrichtung gemäss Schnittlinie VII-VII in Fig. 6,

Fig. 8 einen Schnitt durch die Transportvorrichtung mit angedeuteter integrierter Belackungsstation und Stützeinrichtung gemäss der Linie VIII-VIII in Fig. 6 und

Fig. 9 einen Schnitt durch die Transportvorrichtung mit angedeuteten Querförderern zur Plattenein- bzw. Plattenausgabe gemäss der Linie IX-IX in Fig. 6.

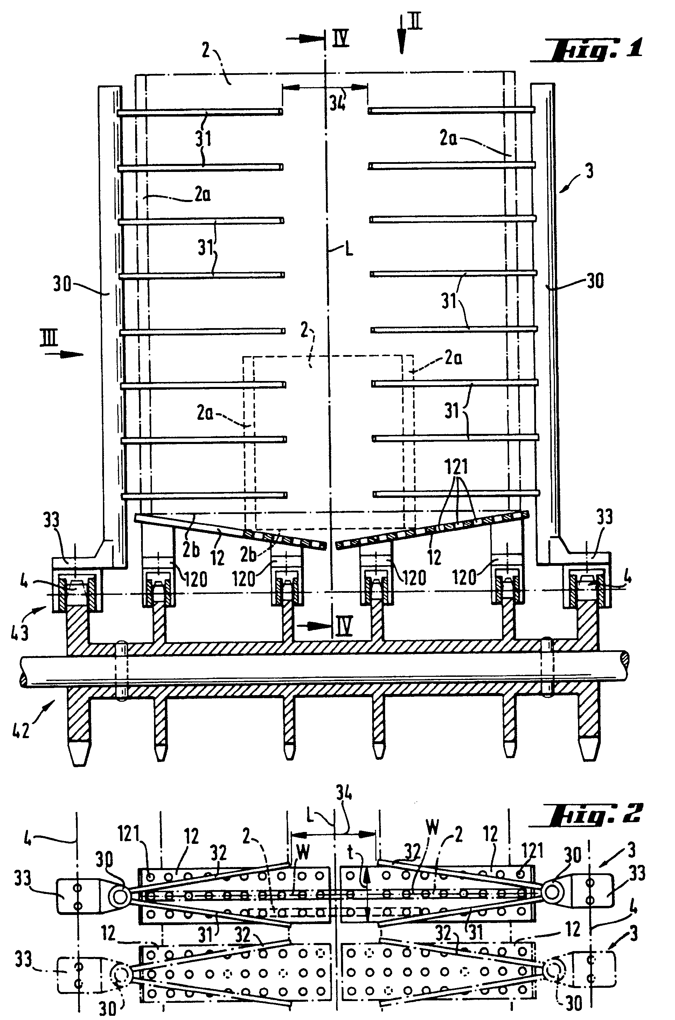

Eine in den Fig. 6-9 im Ganzen mit 1 bezeichnete Transportvorrichtung für Platten 2 oder plattenförmige Werkstücke, insbesondere mit empfindlicher Oberfläche, z.B. für Leiterplatten, die mit Kunststoff oder mit Lack beschichtet und dann getrocknet werden sollen, weist als wesentliche Elemente vor allem die in den Fig. 1-5 dargestellten Halter 3 zum Erfassen der Platten 2 an den Plattenrändern bei ihrer Handhabung und synchron umlaufende Stützeinrichtungen für die Fussenden der Leiterplatten 2 insbesondere in der Phase ihres horizontalen Transports, bei dem die Leiterplatten 2 in den Haltern 3 senkrecht stehen, auf. Die Halter 3 sind an einem umlaufenden Vorschubmittel, im Ausführungsbeispiel an endlos umlaufenden Ketten 4 zum Transport der Halter 3 und der Platten 2 durch verschiedene noch zu beschreibende Bearbeitungsstationen, wie eine Vortrocknungsstation 5, eine Trocknungsstation 6 und eine Kühlstation 7 befestigt. Zusätzlich sind in die Vorrichtung 1 auch noch Querförderer 15 integriert, mit welchen die Leiterplatten 2 an Ein- bzw. Ausgabestationen 16 bzw. 17 in die Transportvorrichtung 1 eingebracht bzw. aus ihr entfernt werden können.

Damit die Platten 2 bei ihrer Handhabung vor allem nach einer Beschichtung an ihrer empfindlichen Oberfläche nicht beschädigt werden können, ist die Ausbildung der Halter 3 in mehrfacher Hinsicht von wesentlicher Bedeutung. Einerseits sollen die Platten 2 bei ihrem Transport in den Haltern 3 nicht an der beschichteten Oberfläche berührt werden, andererseits müssen die Platten 2 auch problemlos in die Halter 3 einbringbar und wieder aus den Haltern 3 entnehmbar sein.

Gemäss den Fig. 1-5 weist daher jeder Halter 3 zwei parallele Holme 30 auf, an denen jeweils zwei Reihen 31 und 32 von rechenförmig angeordneten Zinken vorgesehen sind. Die Zinken der einen Reihe 31 eines Holmes 30 schliessen dabei gemäss Fig. 2 mit denen der zweiten Reihe 32 einen spitzen Winkel ein, d.h., die beiden Reihen 31 und 32 sind im Querschnitt gesehen - V-förmig zueinander angeordnet. Die freien Enden der Zinken des einen Holmes 30 sind dabei gegen die freien Enden der Zinken des anderen Holmes 30 gerichtet, was man wiederum gut in Fig. 2 erkennt. Der lichte Abstand zwischen den jeweils zu einem Holm 30 gehörenden beiden Zinkenreihen 31 und 32 nimmt also zu der in Fig. 1, 2 und 5 als strichpunktierte Linie L angedeuteten Längsmittelebene zwischen den beiden Holmen 30 zu.

Dabei ist in Fig. 1, 2 und 5 gestrichelt eine Platte 2 angedeutet, wobei in Fig. 1 und 5 auch die lackfreien Ränder 2a parallel zu den Holmen erkennbar sind. In den Fig. 1 und 5 ist dabei gestrichelt eine kleinste Platte 2, die von einem Halter 3 erfasst werden kann, und strichpunktiert eine grösste Platte 2 dargestellt. In Fig. 2 wird dabei deutlich, dass der zur Längsmittelebene L hin zunehmende lichte Abstand zwischen den Zinkenreihen 31 und 32 über einen grossen Teil des zwischen den Holmen 30 befindlichen Bereiches grösser als die Dicke der zu haltenden Platten 2 ist, so dass die Oberflächen dieser Platten 2 auch bei einem Durchhängen der Leiterplatte nicht auf den Zinken aufliegt.

Unmittelbar an oder neben dem jeweiligen Holm 30 ist der lichte Abstand zwischen den V-förmig zueinander angeordneten Zinkenreihen 31 und 32 kleiner, an einer Uebergangsstelle, nämlich der in Fig. 2 angedeuteten Berührstelle der Platte 2 mit den Zinken, gleich und benachbart dazu - näher zur Längsmittelebene L des Halters 3 - grösser als die Plattendicke. Es ist allerdings nicht zwingend, dass eine Platte 2 mit ihren Längsrändern gleichzeitig alle Zinken beider Reihen 31 und 32 berührt, wie es in Fig. 2 für die grösstmögliche Platte 2 angedeutet ist, sondern eine kleinere Platte wird jeweils nur die unteren Zinken eines Halters 3 berühren.

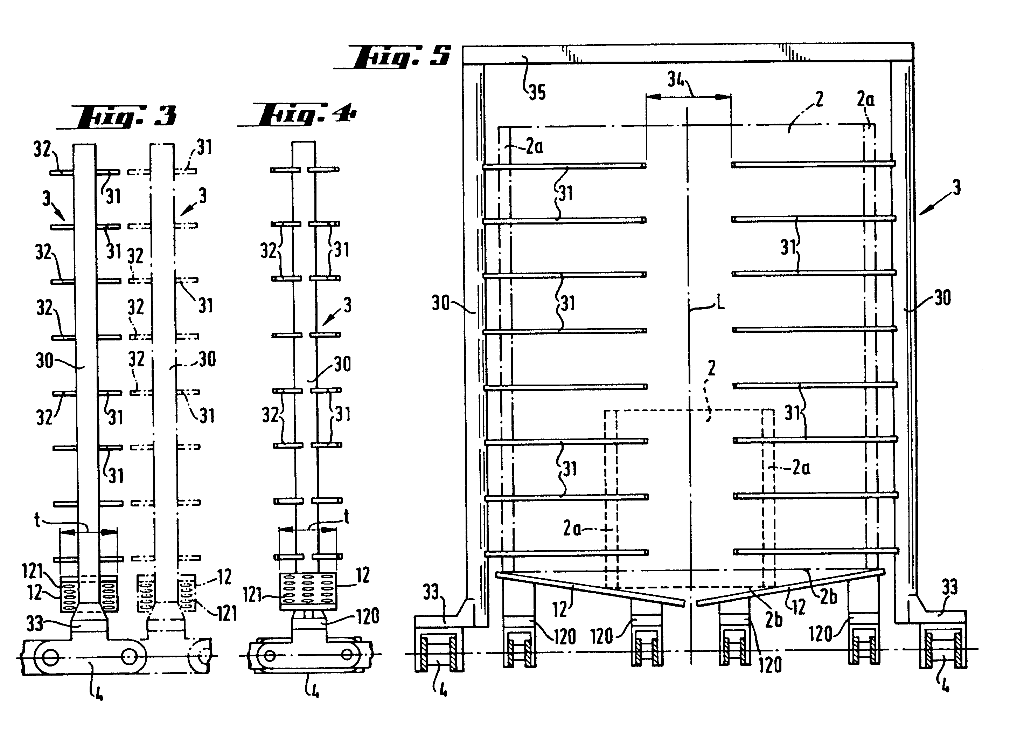

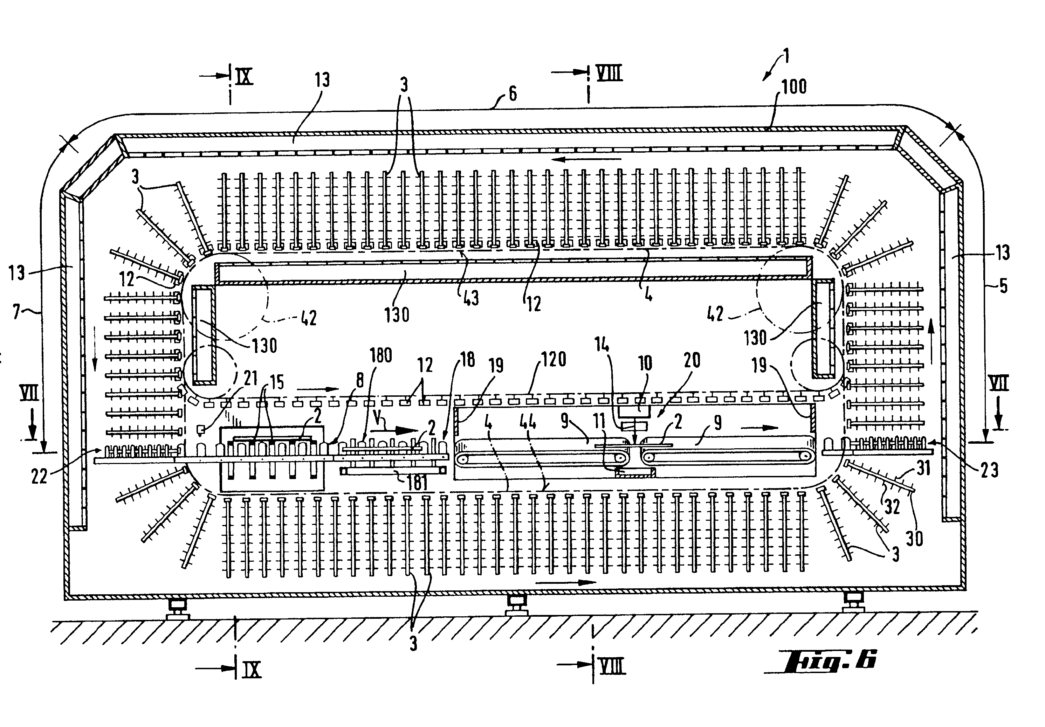

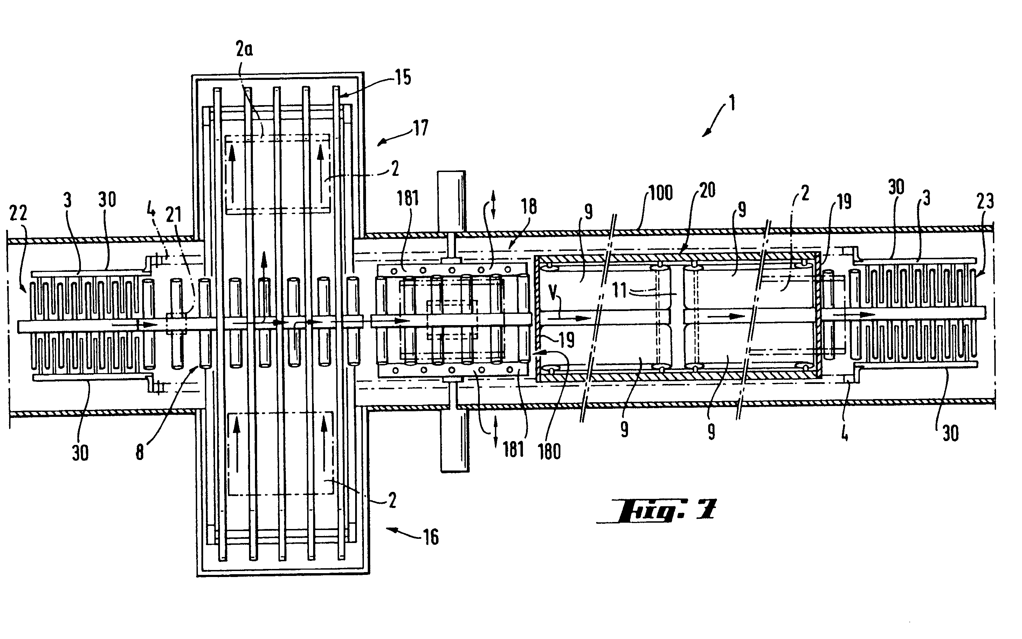

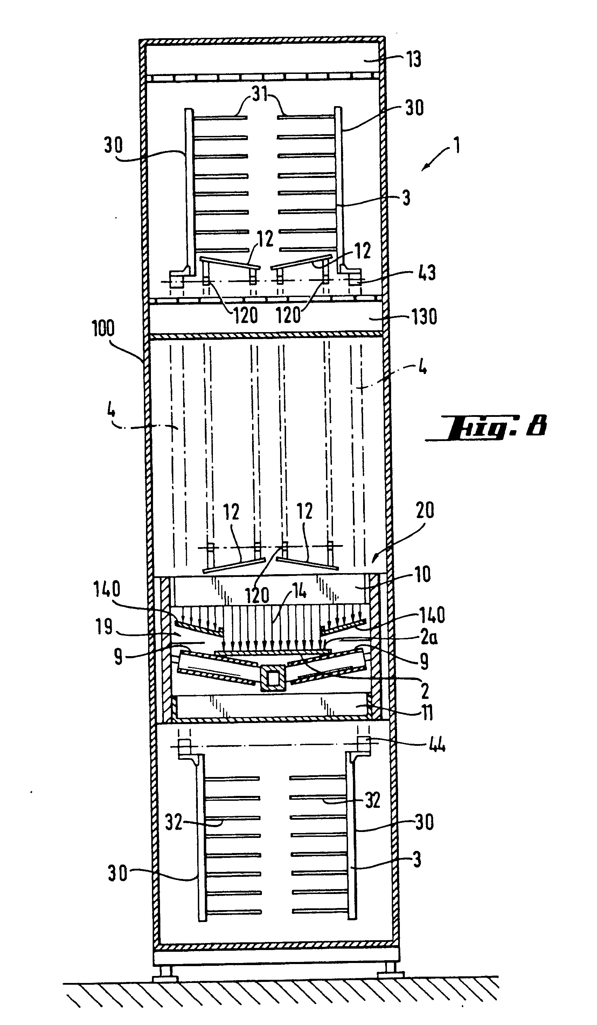

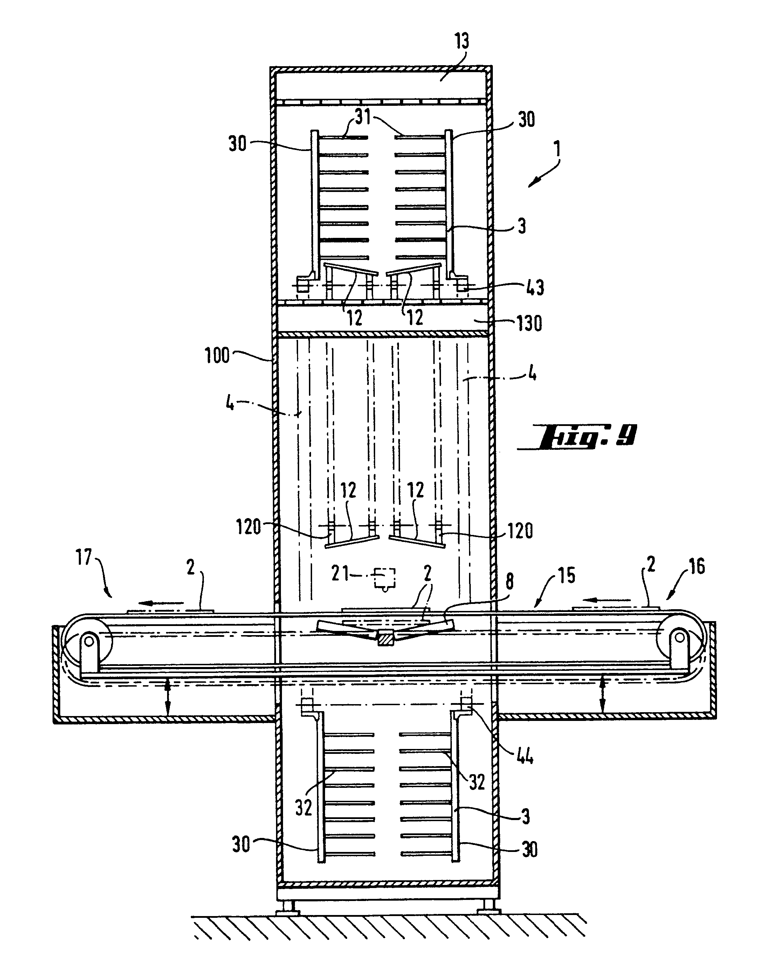

Die Zinkenreihen 31 bzw. 32 sind jeweils parallel zueinander und rechtwinklig zu dem Holm 30 angeordnet. Jeweils zwei unter einem spitzen Winkel etwa von derselben Stelle des Holmes 30 ausgehende Zinken liegen dabei in einer rechtwinklig zu der Erstreckung der Holme 30 und auch rechtwinklig zu der Längsmittelebene L angeordneten Ebene, was vor allem anhand der Fig. 3 und 4 deutlich wird. Die beiden Holme 30 mit ihren V-förmig angeordneten, gegeneinander gerichteten Zinkenreihen 31 und 32 sind spiegelsymmetrisch zu der zwischen den Holmen 30 verlaufenden Längsmittelebene L angeordnet, so dass die Unterstützung einer Platte 2 an dem Halter unabhängig von dessen Orientierung immer gleich ist.

In Fig. 2 erkennt man ferner, dass die Winkelhalbierenden W der von den im Ausführungsbeispiel geraden Zinken des einen Holmes 30 jeweils gebildeten spitzen Winkel mit denen der von den Zinken des anderen Holmes 30 gebildeten Winkeln übereinstimmen. Beide Winkelhalbierenden W setzen sich zu einer geraden Linie fort, so dass alle Winkelhalbierenden W der von den Zinken der Holme 30 jeweils gebildeten spitzen Winkel mit den Holmen 30 in einer gemeinsamen Ebene liegen, die von der Längsmittelebene L geschnitten wird und zu der diese Längsmittelebene L rechtwinklig angeordnet ist.

Der Abstand zwischen jeweils einander in den Reihen 31 bzw. 32 benachbarten Zinken ist grösser als die seitliche Ausdehnung dieser Zinken und beträgt z.B. das Fünffache bis Zehnfache, insbesondere das Siebenfache oder Achtfache des Zinkendurchmessers oder der Zinkenbreite. Gemäss den dargestellten Ausführungsbeispielen sind die Zinken gerade, jedoch könnten sie u.U. auch bogenförmig sein, wobei ihre Krümmung zweckmässigerweise in derjenigen Ebene liegt, deren Draufsicht in Fig. 2 dargestellt ist.

Zwischen den freien Enden der einander vorzugsweise genau in einer gemeinsamen Ebene gegenüberliegenden Zinken eines Halters 3 ist ein Zwischenraum 34 (vgl. Fig. 1 bzw. 5) vorgesehen, der kleiner ist, als es der geringsten Breite einer zu haltenden Platte oder Leiterplatte 2 entspricht. Die Abmessung dieses Zwischenraumes 34 beträgt vorzugsweise etwa ein Sechstel bis ein Viertel, insbesondere ein Fünftel des Abstandes der beiden parallelen Holme 30.

Der Abstand der Holme 30 zueinander und damit auch der Zwischenraum 34 kann aber auch verstellbar sein (nicht dargestellt). Dadurch lässt sich eine Anpassung an in ihren Abmessungen noch weiter von einander abweichende Platten 2 durchführen, als sie in den Fig. 1 bzw. 5 angedeutet sind.

Gemäss den Fig. 1-5 weisen die Holme 30 an ihren Fussenden Kupplungsstücke 33 auf, mit welchen die Halter 3 an den umlaufenden Vorschubmitteln, hier insbesondere an der endlos umlaufenden Transportkette 4 befestigt werden können.

Die in den Fig. 1 bzw. 5 dargestellten Ausführungsbeispiele von Haltern 3 sind an ihrem den Vorschubketten 4 zugewandten Fussende offen ausgebildet. Auf diese Weise ausgebildet erlaubt der Halter 3 ein einfaches horizontales Ein- und Ausfahren der Leiterplatte 2, welches im folgenden noch näher beschrieben wird. Die gegenüberliegende Stirnseite der Halter 3 kann, wie in den Fig. 1-4 dargestellt, gleichfalls offen ausgebildet sein. Aus Gründen einer besseren Steifigkeit der Halter 3 können die Holme 30 am gegenüberliegenden Stirnende aber auch durch ein angeschweisstes, angeschraubtes oder anderswie befestigtes Verbindungsstück 35 verbunden sein, wie dies in Fig. 5 dargestellt ist.

Um zu verhindern, dass eine in einem Halter 3 befindliche Leiterplatte 2 beim Uebergang vom vertikalen Transport der Halter 3 in liegender Stellung zum horizontalen Transport der Halter 3 in aufrechter Stellung durch das offene kettenseitige Fussende des Halters 3 herausrutscht, ist die Transportvorrichtung 1 mit einer synchron zu den Vorschubmitteln, hier der Transportkette 4 mit den daran befestigten Haltern 3, umlaufenden Stützeinrichtung 12 ausgestattet. Diese Stützeinrichtung 12 weist eine geringere Breite auf als die lichte Weite zwischen den beiden Holmen 30 eines Halters 3 und ist während des Horizontaltransports und während des Uebergangs vom Horizontalzum Vertikaltransport der Halter 3 stets im Bereich der offenen Fussenden der Halter 3 angeordnet. Die Stützeinrichtung 12 ist als endlos umlaufende Ketten, Bänder, Seile oder ähnliches ausgebildet. In den in den Fig. 1-5 dargestellten Ausführungsbeispiel umfasst die Stützeinrichtung 12 zwei V-förmig in stumpfem Winkel zueinander angestellte Gliederbänder, die über Führungsmittel 120 mit Vorschubmitteln verbunden sind. Die Tiefe t der einzelnen Glieder der Gliederbänder 12 ist vorzugsweise an den grössten Abstand der Vorderenden der V-förmig angeordneten Zinken 31, 32 eines Holmes 30 angepasst und stimmt mit diesem überein. Die Gliederbänder weisen Perforationen 121 auf, welche einen weitgehend ungehinderten Lufttransport durch die Gliederbänder erlauben. Beim Uebergang vom vertikalen zum horizontalen Transport und umgekehrt und während des horizontalen Transports der Halter 3 dienen die Gliederbänder 12 für die von der liegenden in die stehende Position übergeführten Leiterplatten 2 als Anschlag. Die Fussenden 2b der Leiterplatten 2 stützen sich auf den zwei V-förmig zueinander angestellten Gliederbändern 12 ab. Der stumpfe Winkel, unter dem die beiden Gliederbänder zueinander geneigt sind, bewirkt dabei, dass im wesentlichen nur die lackfreien Bereiche der Fussenden 2b der Platten 2 auf den Gliederbändern 12 aufliegen, im Idealfall erfolgt nur ein linienförmiger Kontakt an den lackfreien Stellen. Auf diese Weise ist sichergestellt, dass es zu keinen Verschmutzungen der Gliederbänder 12 durch anhaftenden Lack kommt.

Der Vorschub der endlos umlaufenden Gliederbänder 12 ist derart geregelt, dass er vollkommen synchron zum Verschub der Halter 3 erfolgt. Vorzugsweise sind die beiden Vorschubmittel gekoppelt, beispielsweise dadurch, dass die Gliederbänder 12 und die endlos umlaufenden Ketten 4 an den Umlenkpunkten 42 im oberen Trum 43 gekoppelt sind. Diese Kopplung könnte zum Beispiel über gemeinsame Umlenkrollen erfolgen. Anstatt V-förmig zueinander angestellten Gliederbänder 12 könnte die Stützeinrichtung auch mehrere endlos umlaufende Seile oder Ketten umfassen, welche niveaumässig versetzt sind, derart, dass im Querschnitt eine ähnliche V-förmige Ausrichtung erreicht wird wie mit den beiden Gliederbändern.

In den Fig. 6-9 ist eine Transportvorrichtung 1 für Leiterplatten dargestellt. Die Transportvorrichtung 1 umfasst Halter 3 gemäss dem Ausführungsbeispiel nach den Fig. 1-4, die an endlos umlaufenden Ketten 4 montiert sind. Die endlos umlaufende Stützeinrichtung ist mit 12 bezeichnet. Die endlos umlaufenden Ketten 4 und die endlos umlaufende Stützeinrichtung 12 sind über gemeinsame symbolisch angedeutete Umlenkrollen 42 geführt und derart gekoppelt. Ihr Vorschub, der üblicherweise getaktet erfolgt, verläuft dadurch völlig synchron.

Wie bereits erwähnt und in den Fig. 6 und 7 dargestellt, ist als Vorschubmittel für die Vielzahl von in gleichbleibendem Abstand zueinander daran angeordneten Halter 3 ein endlos umlaufendes Zugelement, welches also in Zugrichtung Kräfte übertragen kann, dies aber quer dazu oder in Druckrichtung nicht oder kaum vermag, im Ausführungsbeispiel die schon erwähnten Ketten 4 vorgesehen. Auch entsprechend stabile Bänder, Seile oder dergleichen sind möglich. Dabei wird vor allem in Fig. 6 deutlich, dass die Holme 30 der Halter 3 etwa rechtwinklig zur Längserstreckung und Bewegungsrichtung der Ketten 4 nach aussen abstehen, wobei die freien, der Stützeinrichtung 12 abgewandten Enden der Holme 30 von den Ketten 4 weggerichtet sind. Somit können die Halter 3 und ihre Holme 30 an den Umlenkstellen aus ihrer sonst parallel zueinander orientierten Lage problemlos in eine Winkelstellung relativ zueinander übergehen, also die Umlenkung mitmachen.

Die erfindungsgemässe Transportvorrichtung 1 weist eine Reihe von auf engstem Raum innerhalb eines Gehäuses 100 integrierten Behandlungsstationen für die Leiterplatten 2 auf. Im Anschluss an eine vorzugsweise V-förmige Einlaufrollenbahn 8 ist eine Zentrierstation 18 angeordnet. Diese umfasst eine vorzugsweise V-förmige Rollenbahn 180 und einen beidseitig der Rollenbahn angeordneten Zentrierrechen 181, welcher beispielsweise hydraulisch senkrecht zur Vorschubrichtung V horizontal verschiebbar ist. Auf diese Weise werden auch fallweise getwistete Platten 2 exakt ausgerichtet und zentriert. Im Anschluss an die Zentrierstation 18 ist die Belackungsstation 20 angeordnet. Diese umfasst einen oberhalb des unteren Trums 44 der Vorschubkette 4 angeordneten Giesstisch 9 konventioneller Bauart. Oberhalb des Giesstisches 9 ist ein Giesskopf 10 für ein vorzugsweise vorhangartiges Giessen des Lackes 14 angeordnet. Verstellbare (nicht dargestellt) Breitenbegrenzungsmittel 140 begrenzen die Breite des Giessvorhanges 14 und erlauben die Erstellung des lackfreien Randes 2a auf den Leiterplatten 2. Unterhalb des Giesstisches 9 ist eine Auffangeinrichtung 11 für überschüssigen Lack angeordnet. Vor und hinter der Belackungsstation 20 sind vorzugsweise Abschottbleche 19 angeordnet.

In Vorschubrichtung V hinter der Belackungsstation ist eine Eingaberollenbahn 23 angeordnet. Die Eingaberollenbahn 23 umfasst eine Reihe antreibbarer Rollenpaare, welche vorzugsweise in einem Winkel V-förmig zueinander angestellt sind, der dem stumpfen Winkel der zueinander angestellten Zinken 31 bzw. 32 eines Holmpaares 30 entspricht. Der Abstand zwischen den Rollenpaaren und die Gesamtbreite der Rollenbahn 23 ist dabei so bemessen, dass die Zinken 31, 32 eines Halters 3 ungehindert zwischen den Rollenpaaren hindurchtreten können. Mit Hilfe dieser Eingaberollenbahn 23 werden die beschichteten Platten 2 in die Halter 3 eingegeben.

Die Halter 3 werden sodann von der endlos umlaufenden Vorschubkette 4 zuerst vertikal durch die Vortrocknungsstation 5, sodann horizontal durch die Trocknungsstation 6 und schliesslich wieder vertikal durch die Kühlstation 7 transportiert. Der gesamte Vorgang des Vortrocknens und Abluftens des Trocknens und des anschliessenden Kühlens und Nachtrocknens erfolgt somit im wesentlichen oberhalb der Belackungsstation 20. Innerhalb dieses Bereiches weist das Gehäuse 100 im Inneren angeordnete Zuluft- und Absaugeinrichtungen in Form von Zuluftkanälen 13 an den Aussenseiten der Halter 3, über die Heissluft- bzw. Kaltluft in den Trocknungsbereich eingeblasen werden kann, und Absaugkanäle 130 im Bereich der Fussenden der Halter 3, innerhalb der endlos umlaufenden Stützeinrichtung 12, auf. Auf diese Weise wird die Trocknungs- und Kühlluft im wesentlichen parallel zu den Platten 2 zwischen den Haltern 3 hindurchgeführt. Eine Beeinträchtigung der Luftströmung durch die Gliederbänder der Stützeinrichtung 12 ist durch die Perforation der einzelnen Gliedei weitergehend vermieden. Bei im Abstand voneinander angeordneten endlos umlaufenden Seilen oder Ketten als Stützeinrichtung 12 ist ohnehin kaum eine Beeinträchtigung der Luftströmung zu befürchten.

Etwa auf Höhe des unteren Dritteis der vertikalen Aufwärtsbewegung der Halter 3 wird die Stützeinrichtung 12 an die offenen Fussenden jedes Halters 3 herangeführt, um diese zu verschliessen und die transportierten Platten 2 während des Horizontaltransportes durch die Trocknungsstation 6 und auch schon während des Ueberganges vom Vertikal- zum Horizontaltransport der Halter 3 abzustützen. Die untere Umlenkung der endlos umlaufenden Stützeinrichtung erfolgt etwa im unteren Drittel der Vertikalförderung der Halter 3, sodass die kettenseitigen Fussenden der Halter 3 an einer im Anschluss an die Kühlstation 7 angeschlossenen und vor der Einlaufrollenbahn 8 angeordneten Entnahmerollenbahn 22 wieder freigegeben und offen sind. Die Ausbildung der Entnahmerollenbahn 22 ist analog zu der der Eingaberollenbahn 23 und erlaubt eine einfache und schonende Entnahme der Leiterplatten 2 aus den Haltern 3. Die leeren Halter 3 werden im unteren Trum 44 der endlos umlaufenden Vorschubkette 4 waagrecht unterhalb der Eingaberollenbahn 8, der Zentrierstation und des Giesstisches 9 wieder zur Eingaberollenbahn 23 transportiert.

Die Einlaufrollenbahn 8 steht in Verbindung mit einer Eingabe- und einer Ausgabestation 16 bzw. 17. Zwischen den vorzugsweise V-förmig angeordneten Rollenpaaren sind Querförderer 15 angeordnet, welche beispielsweise hydraulisch über bzw. unter das Transportniveau der Einlaufrollenbahn 8 anheb- bzw. absenkbar sind. Vorzugsweise sind diese Querförderer 15 als zwischen den Rollenpaaren endlos umlaufende Bänder oder Seile ausgebildet. In Fig. 9 ist symbolisch ein endlos umlaufendes Hubband 15 in angehobener (ausgezogene Linie) und in abgesenkter (strich-punktierte Linie) Stellung dargestellt. Das Transportniveau der V-förmig angestellten Rollenpaare der Einlaufrollenbahn 8 ist gleichfalls angedeutet. In angehobenem Zustand des Querförderers 15 kann über die Eingabestation 16 eine Platte 2 in die Transportvorrichtung 1 eingefahren werden bzw. aus der Transportvorrichtung 1 zur Ausgabestation 17 ausgefahren werden. Mit Hilfe dieser Querförderer 15 kann die Transportvorrichtung 1 auf einfache Art mit anderen Anlagen kombiniert werden. Einzig die Uebergabeeinrichtungen müssen gegebenenfalls angepasst werden. In den meisten Fällen dürfte aber selbst diese geringe Anpassungsarbeit entfallen, da im Zusammenhang mit dem Transport von Leiterplatten üblicherweise genormte Rollenbahnen verwendet werden.

Im folgenden soll anhand des Durchlaufs einer Leiterplatte die Funktion der erfindungsgemässen Transportvorrichtung näher erläutert werden.

Die Leiterplatte 2 wird an der Eingabestation 16 vom angehobenen Querförderer 15, vorzugsweise Hubbändern, von nicht dargestellten Uebergabeeinrichtungen anderer Anlagen übernommen. Von den Hubbändern 15 wird die Leiterplatte 2 getaktet in das Innere des Gehäuses 100 der Transportvorrichtung transportiert und durch Absenken der Hubbänder 15 auf die Einlaufrollenbahn 8 abgesenkt. Von dort wird die Leiterplatte 2 im Vorschubrichtung V zur Zentrierstation 18 transportiert, wo sie exakt ausgerichtet und zentriert wird. Nach dem Zentrieren gelangt die Leiterplatte 2 auf den Giesstisch 9 der Belackungsstation 20, wo sie üblicherweise auf eine grössere Geschwindigkeit beschleunigt, unter dem breiten-begrenzten Lackvorhang 14 hindurchtransportiert wird. Dabei wird ihre Oberfläche mit Lack (üblicherweise lichtempfindlichem Lack) beschichtet, wobei die Breitenbegrenzung 140 des Lackvorhanges 14 für den lackfreien Rand 2a sorgt. Selbstverständlich könnte der Lack auch aufgesprüht, beispielsweise in einem elektrostatischen Sprühverfahren bekannter Art aufgebracht werden. Ausgangsseitig der Belackungsstation 20 wird die einseitig beschichtete Leiterplatte 2 zu einer V-förmigen Eingaberollenbahn 23 transportiert. An der Eingaberollenbahn 23 erfolgt die Uebergabe der Leiterplatte 2 an die Halter 3. Dazu wird ein Halter 3 von den Vorschubmitteln 4 in eine Position getaktet, in der die oberen Zinken 31 der Holme 30 sich oberhalb der Rollen der Eingaberollenbahn 23 befinden und die unteren Zinken 32 der Holme 30 etwas unterhalb. Vorzugsweise sind die unteren Zinken 32 und die Rollenpaare bezüglich ihres stumpfen Anstellwinkels angeglichen. Nach dem Einfahren der Leiterplatte 2 durch das kettenseitige offene Fussteil in den Halter 3, wird sie beim nächsten Takt von dem Halter 3 hochgehoben, wobei der nächste Halter 3 in die Eingabeposition getaktet wird. Beim vertikalen Transport durch die Vortrocknungs- und Abluftstation 5 liegt die waagrecht transportierte Leiterplatte 2 nur mit den Aussenrändern der unbeschichteten Seite an den unteren Zinken 32 auf. Etwa im ersten Drittel des Vertikaltransportes der Halter 3, etwa eingangsseitig der Vortrocknungs- und Abluftstation 5 werden die offenen Fussenden von der endlos umlaufenden Stützeinrichtung 12 verschlossen. Beim Uebergang vom getakteten Vertikaltransport in den getakteten Horizontaltransport der Halter 3 richten sich diese in senkrechte Stellung auf, die Leiterplatten 2 gleiten gegebenenfalls etwas nach unten, bis sie sich auf der Stützeneinrichtung 12 abstützen. Auf diese Weise werden die einseitig beschichteten Leiterplatten 2 stehend durch die Trocknungsstation 6 transportiert. Am oberen Umlenkpunkt 42 ausgangs der Trocknungsstation 6 werden die Halter 3 wieder in einen vertikalen Abwärtstransport umgelenkt. Dabei befinden sich nun die zuvor oberen Zinken 31 unten und die zuvor unteren Zinken 32 oben. Zugleich wird die getrocknete einseitig beschichtete Leiterplatte 2 gewendet, sodass sie nun mit dem lackfreien Rand 2a auf den Zinken 31 aufliegt. Auf diese Weise liegend wird die Leiterplatte 2 durch die Nachtrocknungs- und Kühlstation 7 transportiert. Etwa im unteren Drittel des Vertikaltransports der Halter 3, etwa ausgangsseitig der Nachtrocknungs- und Kühlstation 7, wird die endlos umlaufende Stützeinrichtung 12 umgelenkt und gibt so das offene kettenseitige Fussende der Halter 3 frei. Der Halter 3 mit der gewendeten Leiterplatte 2 wird getaktet bis zur Entnahmerollenbahn 22 bewegt. Dabei wird der Halter 3 in eine Position getaktet, in der die Leiterplatte 2 bereits auf den V-förmig angestellten Rollen der Entnahmerollenbahn 22 aufliegt, die nun oberen Zinken 32 sich jedoch noch oberhalb des Transportniveaus befinden. Daraufhin wird die Entnahmerollenbahn 22 in Bewegung versetzt, und die Leiterplatte 2 mit der beschichteten Seite nach unten in Richtung der Einlaufrollenbahn 8 durch das offene kettenseitige Fussende der Halter 3 ausgefahren. Vorzugsweise ist unmittelbar vor der Einlaufrollenbahn 8 eine Sensoreinrichtung 21, vorzugsweise ein optischer Detektor angeordnet, der den Zustand der Leiterplattenoberfläche (beschichtet, unbeschichtet) detektiert. Je nach Wunsch generiert dieser ein Steuersignal und gibt dieses an eine in den Fig. jeweils nicht dargestellte Steuerungsanlage weiter. Diese entscheidet daraufhin, ob die Leiterplatte 2 ein zweites Mal die Transportvorrichtung 1 durchläuft, beispielsweise um auch die zweite Seite zu beschichten, oder ob die Leiterplatte 2 aus der Transportvorrichtung 1 ausgefahren wird. Im letzteren Fall wird die Leiterplatte 2 durch Anheben der Hubbänder 15 von der Einlaufrollenbahn 8 abgehoben und zur Ausgabestation 17 transportiert, wo sie an weitere nicht dargestellte Uebernahmeeinrichtungen übergeben werden kann.

Insgesamt ergibt sich somit eine Transportvorrichtung 1 mit integrierter Belackungsstation 20, in der Platten 2 schonend gehandhabt werden können. Der Transport der Leiterplatten 2 durch die gesamte Transportvorrichtung 1 erfolgt getaktet. Um die Leiterplattenbeschichtung nach ihrem Aufbringen so gut wie möglich zu schonen, sollen die Platten 2 nach Möglichkeit nur an ihren Längsrändern 2a von den verschiedenen Transportmitteln berührt werden. Deshalb werden diese alle vorzugsweise V-förmig ausgebildet. Auf Grund der Ausbildung der Halter 3 können diese die Leiterplatten nach einem ersten Beschichtungsvorgang einfach aufnehmen, während einer Belüftung, Trocknung und Kühlung transportieren, haltern und wenden. Die Platten können auch wieder problemlos und ohne Gefahr für die Oberflächenbeschichtung aus den Haltern entnommen werden und können erforderlichenfalls erneut der Belackungsstation 20 zugeführt werden. Während des Horizontaltransportes der Halter 3 mit senkrecht in ihnen stehenden Leiterplatten 2 stützen sich diese mit ihren Fussenden 2b auf einer endlos umlaufenden Stützeinrichtung 12 ab, die jeweils vor der Eingabe und der Entnahme der Leiterplatten 2 die offenen kettenseitigen Fussenden der Halter 3 wieder freigibt. Da die Platten 2 auf Grund der speziellen Konstruktion der Halter 3 lose in diesen liegen können und dabei nur Kanten- und bei im Querschnitt runden Zinken sogar nur Punktberührung erfahren, brauchen keine aufwendigen Klemmen, Klammern oder dergleichen betätigt oder beim Wechsel der einzelnen Arbeitsstationen umgesetzt zu werden. Da die Halter 3 an den Ketten 4 umlaufen, machen sie automatisch eine Wendebewegung, so dass für die beidseitige Beschichtung nicht zwei Belackungsstationen und dazwischen liegende Trocknungseinrichtungen erforderlich sind, sondern in ein und derselben integrierten Belackungsstation 20 und mit Hilfe nur einer integrierten Trocknungseinrichtung 5, 6, 7 beide Beschichtungen durchgeführt werden können. Insgesamt erlaubt somit nicht zuletzt die zweckmässige Konstruktion der Halter 3 in Verbindung mit der endlos umlaufenden Stützeinrichtung 12 eine platzsparende und in ihrem maschinellen Aufwand rentable Konstruktion der Transportvorrichtung 1 als einzeilige Umlaufbeschichtungsanlage.

**Patentansprüche**

1. Transportvorrichtung (1) für Platten (2) oder plattenförmige Werkstücke mit empfindlicher Oberfläche, insbesondere für Leiterplatten, die mit Kunststoff, zum Beispiel UV-härtbarem Kunststoff, mit Lack oder dergleichen nassbeschichtet und dann getrocknet werden, wobei die Vorrichtung Halter (3) zum Erfassen der Platten (2) an den Plattenrändern (2a) bei ihrer Handhabung und Vorschubmittel (4) zu ihrem Transport zu und durch Bearbeitungsstationen aufweist, dadurch gekennzeichnet, dass der Halter (3) wenigstens zwei parallele Holme (30) hat, an denen jeweils zwei Reihen (31, 32) von rechenförmig angeordneten Zinken vorgesehen sind, wobei die Zinken der einen Reihe (31) eines Holmes (30) mit denen der zweiten Zinkenreihe 32) dieses Holmes (30) einen spitzen Winkel einschliessen, somit im Querschnitt gesehen V-förmig zueinander angeordnet sind, und wobei die freien Enden der Zinken des einen Holmes (30) etwa gegen die freien Enden der Zinken des anderen Holmes (30) gerichtet sind, dass der zu der Längsmittelebene zwischen den beiden parallelen Holmen (30) zunehmende lichte Abstand zwischen den Zinkenreihen (31, 32) wenigstens über einen Teil des zwischen den Holmen (30) befindlichen Bereiches grösser als die Dicke einer zu haltenden Platte (2) ist, dass die Halter (3) offen ausgebildete Fussenden als Be- und Entladeöffnung für die Platten 2 aufweisen und dass die Transportvorrichtung eine im Bereich der Fussenden der Halter (3) angeordnete und synchron mit den Haltern (3) bewegbare Stützeinrichtung (12) für die Platten (2) aufweist.

2. Vorrichtung nach Anspruch 1, dadurch gekennzeichnet, dass der lichte Abstand zwischen den V-förmig zueinander angeordneten Zinkenreihen (31, 32) unmittelbar an oder neben dem jeweiligen Holm (30) kleiner, an einer Uebergangstelle gleich und benachbart dazu - näher zur Längsmittelebene (L) des Halter (3) - grösser als die Plattendicke ist.

3. Vorrichtung nach Anspruch 1 oder 2, dadurch gekennzeichnet, dass die Zinken einer Reihe (31, 32) jeweils parallel zueinander und rechtwinklig zu dem Holm (30) angeordnet sind und dass jeweils zwei unter einem spitzen Winkel etwa von derselben Stelle des Holmes (30) ausgehende Zinken in einer rechtwinklig zu der Erstreckung der Holme (30) angeordneten Ebene liegen.

4. Vorrichtung nach einem der Ansprüche 1 bis 3, dadurch gekennzeichnet, dass die beiden Holme (30) mit ihren V-förmig angeordneten, gegeneinander gerichteten Reihen (31, 32) von Zinken spiegelsymmetrisch zu der zwischen den Holmen (30) verlaufenden Längsmittelebene (L) angeordnet sind.

5. Vorrichtung nach einem der Ansprüche 1 bis 4, dadurch gekennzeichnet, dass die Winkelhalbierenden (W) der von den vorzugsweise geraden Zinken (31, 32) des einen Holmes (30) jeweils gebildeten spitzen Winkel mit denen der von den Zinken (32, 31) des anderen Holmes (30) gebildeten Winkeln übereinstimmen.

6. Vorrichtung nach Anspruch 5, dadurch gekennzeichnet, dass die Winkelhalbierenden (W) der von den Zinken der Holme (30) jeweils gebildeten spitzen Winkel mit den Holme (30) in einer gemeinsamen Ebene liegen, zu der die Längsmittelebene (L) rechtwinklig angeordnet ist.

7. Vorrichtung nach einem der Ansprüche 1 bis 6, dadurch gekennzeichnet, dass der Abstand zwischen jeweils einander in Reihe benachbarter Zinken (31, 32) grösser als die seitliche Ausdehnun dieser Zinken ist, zum Beispiel das Fünffache bis Zehnfache, insbesondere das Siebenfache oder Achtfache des Zinkendurchmessers oder der Zinkenbreite beträgt.

8. Vorrichtung nach einem der Ansprüche 1 bis 7, dadurch gekennzeichnet, dass zwischen den freien Enden der einander vorzugsweise genau in einer gemeinsamen Ebene gegenüber liegenden Zinken (31, 32) eines Halters (3) ein Zwischenraum (34) vorgesehen ist, der kleiner ist, als es der geringsten Breite einer Platte (2) entspricht, und dass die Abmessung dieses Zwischenraumes (34) vorzugsweise etwa ein Sechstel bis ein Viertel, insbesondere ein Fünftel des Abstandes der beiden parallelen Holme (30) beträgt.

9. Vorrichtung nach Anspruch 8, dadurch gekennzeichnet, dass der Zwischenraum (34) verstellbar ist.

10. Vorrichtung nach einem der vorangehenden Ansprüche, dadurch gekennzeichnet, dass die Stützeinrichtung (12) endlos umlaufende Seile, Ketten oder Bänder umfasst.

11. Vorrichtung nach Anspruch 10, dadurch gekennzeichnet, dass die Stützeinrichtung (12) eine geringere Breite aufweist als die lichte Weite zwischen den beiden Holmen (30) eines Halters (3).

12. Vorrichtung nach Anspruch 10 oder 11, dadurch gekennzeichnet, dass die Stützeinrichtung (12) zwei unter stumpfem Winkel V-förmig zueinader angestellte Gliederbänder umfasst.

13. Vorrichtung nach Anspruch 12, dadurch gekennzeichnet, dass die einzelnen Glieder der beiden Gliederbänder (12) perforiert sind.

14. Vorrichtung nach Anspruch 12 oder 13, dadurch gekennzeichnet, dass die Tiefe (t) der einzelnen Glieder der Gliederbänder (12) im wesentlichen dem grössten Abstand der Vorderenden eines V-förmig angeordneten Zinkenpaares (31, 32) eines Holmes (30) entspricht.

15. Vorrichtung nach einem der vorangehenden Ansprüche, dadurch gekennzeichnet, dass die beiden Holme (30) eines Halters (3) an ihrem Stirnende durch ein angeschweisstes, angeschraubtes oder anderswie befestigtes Verbindungsstück (35) verbunden sind.

16. Vorrichtung nach einem der vorangehenden Ansprüche, dadurch gekennzeichnet, dass die beiden parallelen Holme (30) eines Halters (3) im Bereich ihrer Fussenden Befestigungs- oder Kupplungsstücke (33) zum Verbinden mit den Vorschubmitteln (4) für den Transport der Halter (3) und der Platten (2) aufweisen.

17. Vorrichtung nach einem der vorangehenden Ansprüche, dadurch gekennzeichnet, dass als Vörschubmittel (4) für eine Vielzahl von in gleichbleibendem Abstand zueinander daran angeordnete Halter (3) endlos umlaufende Zugelemente, vorzugsweise Ketten, Bänder oder dergleichen, vorgesehen sind, zu deren Längserstreckung und Bewegungsrichtung die Holme (30) der Halter (3) etwa rechtwinklig nach aussen abstehen, wobei die Stirnenden der Holme (30) von den Zugelementen oder Ketten weggerichtet sind.

18. Vorrichtung nach Anspruch 17, dadurch gekennzeichnet, dass die endlos umlaufende Stützeinrichtung (12) und die endlos umlaufenden Vorschubmittel (4) für die Halter (3) an ihren jeweiligen oberen Umlenkpunkten (42) gekoppelt sind.

19. Vorrichtung nach Anspruch 17, dadurch gekennzeichnet, dass die endlos umlaufenden Vorschubmittel (4) und die endlos umlaufende Stützeinrichtung (12) über gemeinsame Umlenkrollen geführt sind, welche an ihren jeweiligen oberen Umlenkpunkten (42) angeordnet sind.

20. Vorrichtung nach einem der vorangehenden Ansprüche, dadurch gekennzeichnet, dass sie in der Reihenfolge des Durchlaufes einer Platte (2) durch die Vorrichtung genannt eine Einlaufrollenbahn (8), eine Zentrierstation (18), eine Belackungsstation (20), eine Eingaberollenbahn (23), einen Trocknungsbereich (5, 6, 7) und eine Entnahmerollenbahn (22) umfasst, die alle in einem gemeinsamen Gehäuse (100) integriert sind.

21. Vorrichtung nach Anspruch 20, dadurch gekennzeichnet, dass der Trocknungsbereich, der eine Vortrocknungs- und Abluftstation (5), eine Trocknungsstation (6) und eine Kühl-und Nachtrocknungsstation (7) umfasst, im wesentlichen oberhalb der Belackungsstation (20) und der Einlaufrollenbahn (8) angeordnet ist.

22. Vorrichtung nach Anspruch 20 oder 21, dadurch gekennzeichnet, dass alle innerhalb der einzelnen Stationen und Rollenbahnen angeordneten Transportmittel im wesentlichen V-förmig ausgebildet sind.

23. Vorrichtung nach Anspruch 22, dadurch gekennzeichnet, dass die unterhalb des Trocknungsbereiches (6) angeordneten Transportmittel im wesentlichen in stumpfem Winkel V-förmig zueinander angeordnete Rollenzeilen oder Förderbänder umfassen, wobei der stumpfe Winkel im wesentlichen mit dem von den gegenüberliegenden Zinkenreihen (31 oder 32) eines Holmpaares (30) eines Halters (3) eingeschlossenen Winkel übereinstimmt.

24. Vorrichtung nach einem der Ansprüche 20 bis 23, dadurch gekennzeichnet, dass die Vortrocknungs- und Abluftstation (5) im wesentlichen den vertikal nach oben umlaufenden Transportweg des Vorschubelementes (V) umfasst, die Trocknungsstation (6) den Transportweg im oberen Trum (43) des Vorschubelementes (4) und die Nachtrocknungsund Kühlstation (7) im wesentlichen der vertikal abwärts verlaufendem Teil des Transportweges des Vorschubelementes (4).

25. Vorrichtung nach einem der Ansprüche 20 bis 24, dadurch gekennzeichnet, dass die Stützeinrichtung (12) jeweils etwa im unteren Drittel der Vortrocknungs- und Abluftstation (5) auf die Fussenden der Halter (3) zu umgelenkt wird bzw. etwa im untern Drittel der Nachtrocknungs- und Kühlstation (7) von den Fussenden der Halter (3) weg umgelenkt wird, wobei sie im ersten Fall das kettenseitige offene Fussende der Halter (3) verschliesst und im zweiten Fall wieder freigibt.

26. Vorrichtung nach einem der Ansprüche 20 bis 25, dadurch gekennzeichnet, dass die Einlaufrollenbahn (8) einen zwischen den Rollenpaaren angeordneten und über das Rollenniveau der Platten (2) anhebbaren bzw. unter das Rollenniveau absenkbaren Querförderer (15) umfasst, welcher eine Eingabe - und eine gegenüberliegende Ausgabestation (16 bzw. 17) bildet, als Schnittstelle zu Uebergabestationen weiterer Anlagen.

27. Vorrichtung nach Anspruch 26, dadurch gekennzeichnet, dass der Querförderer als vorzugsweise hydraulisch heb- und senkbare endlos umlaufende Hubbänder ausgebildet ist, deren Bewegungsrichtung im wesentlichen senkrecht zur Plattentransportrichtung (V) in der Transportvorrichtung (1) verläuft.

28. Vorrichtung nach einem der Ansprüche 20 bis 27, dadurch gekennzeichnet, dass in Plattentransportrichtung (V) gesehen vor der Einlaufrollenbahn (8) eine Sensoreinrichtung (21), vorzugsweise ein optischer Detektor, angeordnet ist, der den Querförderer (15) ansteuert, wenn der vorbestimmte Beschichtungszustand (einseitig, beidseitig) der Platte (2) detektiert wird.

29. Vorrichtung nach einem der vorangehenden Ansprüche, dadurch gekennzeichnet, dass die Halter (3) während ihres Transports durch das parallel zur Plattentransportrichtung (V) in der Belackungsstation (20) bewegbare untere Trum (44) des Vorschubelementes (4) mit ihren äusseren Stimenden nach unten hängen und leer sind.

30. Vorrichtung nach einem der Ansprüche 20-29, dadurch gekennzeichnet, dass die Belackungsstation (20) eine Vorhanggusseinrichtung (10, 11) umfasst, wobei die Breite des Lackvorhanges (14) durch Breitenbegrenzungsmittel (140) einstellbar ist.

Fig. 1

Fig. 2

Fig. 5

Fig. 4

Fig. 3

Fig. 6

EP 0 441 743 A1

Fig. 1

*Fig. 8*

*Fig. 9*

**Europäisches Patentamt**

# EUROPÄISCHER RECHERCHENBERICHT

Nummer der Anmeldung

EP    91 81 0061

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A, D | EP-A-0252882 (CIBA-GEIGY)<br>* Seite 6, Zeile 28 - Seite 8, Zeile 18; Figuren 1-7 *<br>--- | 1, 2, 10, 21, 24, 25 | H05K13/00 |
| A, D | EP-A-0312498 (CIBA-GEIGY)<br>* Spalte 15, Zeile 7 - Spalte 17, Zeile 54; Figuren 1, 19, 20 *<br>--- | 1, 10 | |
| A, D | FR-A-2439734 (RIVES)<br>* Ansprüche 1-4; Figuren 1-5 *<br>----- | 1, 10, 28 | |
| | | | **RECHERCHIERTE SACHGEBIETE (Int. Cl.5)**<br><br>H05K<br>B65G |

Der vorliegende Recherchenbericht wurde für alle Patentansprüche erstellt

| Recherchenort | Abschlußdatum der Recherche | Prüfer |
|---|---|---|
| DEN HAAG | 17 MAERZ 1991 | LOMMEL A. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

.........................................................................
& : Mitglied der gleichen Patentfamilie, übereinstimmendes Dokument

EPO FORM 1503 03.82 (P0403)